# FASCICULE DE BREVET EUROPEEN

(11) **EP 1 331 712 B1**
(45) Date de publication et mention de la délivrance du brevet: **18.04.2012**
(21) Numéro de dépôt: 03075468.3
(22) Date de dépôt: 23.01.2003
(51) Int. Cl.: H02B 1/052

(54) **Appareil électrique à fixer sur un profilé chapeau**
Elektrisches Gerät zur Befestigung auf einer Hutprofiltragschiene
Electrical device for mounting on a top-hat rail

(30) Priorité: 25.01.2002 FR 0201002
(43) Date de publication de la demande: 30.07.2003
(73) Titulaire: Schneider Automation Inc., North Andover, Massachusetts 01845 (US)
(72) Inventeur: Bet, Robert, 21370 Velar s/Ouche (FR); Delvaux, Fréderic, 21000 Dijon (FR); Girard, Michel, 21910 Corcelles-les-Citeaux (FR); Rix, Philippe, 21240 Talant (FR)
(74) Mandataire: Dufresne, Thierry

(56) Documents cités:
- EP-A- 0 740 499

## Description

La présente invention concerne un appareil électrique comprenant une embase à fixer sur un profilé porteur, conformément au préambule de la revendication 1. Un tel appareil électrique est décrit dans le document EP-A-0 740 499.

Le document FR 2 730 353 montre un dispositif de verrouillage d'un appareil électrique sur un rail profilé porteur, le dispositif possédant deux crans reliés entre eux par une entretoise d'écartement dont la déformation élastique peut être provoquée par une tirette accessible de l'avant. Le dégagement du dispositif à partir du rail s'effectue au moyen d'une tirette latérale dont la manipulation n'est pas aisée. De plus, un tel dispositif n'est pas adapté à la réception sécurisée d'un autre organe constituant d'un appareil électrique à embase, notamment un module de traitement, un bornier, etc...rapporté de façon amovible sur l'embase.

L'invention a pour but de fixer une embase sur un profilé porteur tout en permettant de déverrouiller l'embase par des moyens d'une part faciles à manoeuvrer, d'autre part propres à sécuriser l'apport d'un autre organe constituant de l'appareil sur l'embase.

Afin de résoudre ce but, l'invention propose un appareil électrique comportant les caractéristiques énoncées à la revendication 1.

D'autres caractéristiques avantageuses de l'appareil électrique selon l'invention sont énoncées dans les revendications dépendantes 2 à 10.

La description va être faite ci-après d'un mode de réalisation non limitatif de l'invention, en regard des dessins annexés.

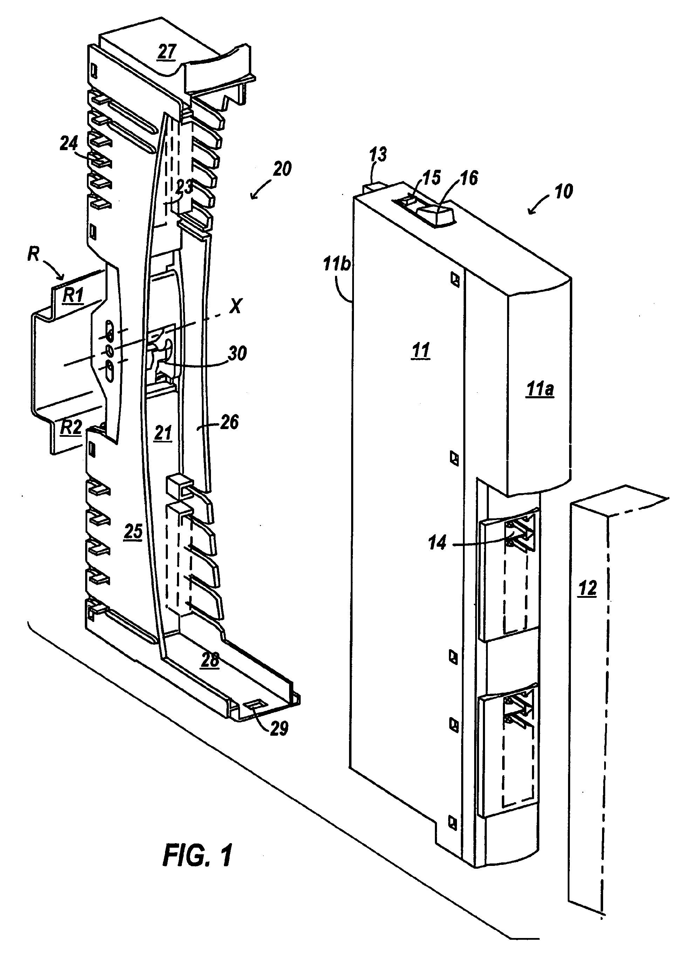

La figure 1 représente en perspective éclatée un appareil modulaire conforme à l'invention.

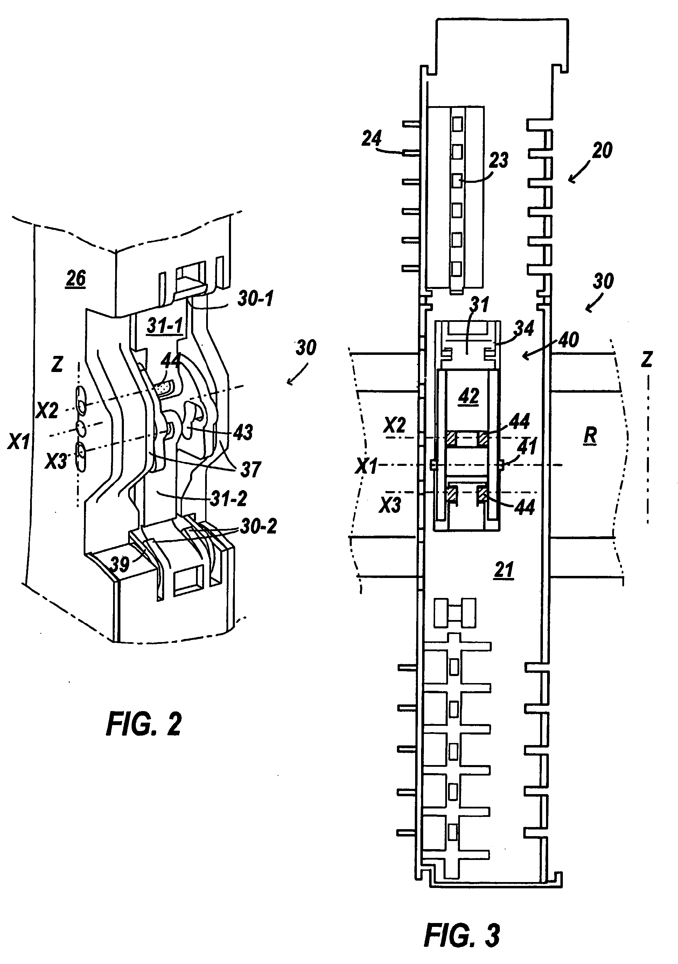

La figure 2 montre en perspective arrière la partie centrale de l'embase de l'appareil de la figure 1.

La figure 3 est une vue de face de l'embase, le levier étant dans sa position de verrouillage.

La figure 4 est une vue de côté de l'embase, le levier étant dans sa position de verrouillage (en traits pleins) et dans sa position de déverrouillage (en tirets).

Les figures 5 et 6 montrent en perspective avant et e vue de côté le levier déverrouillé.

La figure 7 est une vue en perspective éclatée du levier et de l'un des coulisseaux associés.

L'appareil illustré sur les figures comprend plusieurs modules électroniques 10 destinés à être emboîtés et encliquetés dans des embases individuelles 20 elles-mêmes encliquetables en adjacence par tous moyens usuels sur un profilé chapeau porteur. En variante, plusieurs modules 10 peuvent être emboîtés dans des logements adjacents ménagés dans une seule et même embase. Le profilé chapeau R a un profil normalisé à deux branches opposées R1,R2 et s'étend selon une direction X. Dans l'état de fonctionnement de l'appareil, le module est fixé sur l'embase.

Chaque module 10 comprend un boîtier 11 présentant une face avant 11a et une face arrière 11b. A la face avant 11a peut être fixé un bornier 12 de raccordement externe à des organes électriques d'automatisme à commander ou surveiller, des connexions 14 étant prévues vers la face avant 11a pour coopérer avec des connexions ou contacts complémentaires du bornier 12. Des éléments de connexion ou contacts arrière 13 sont disposés vers la face arrière 11b du boîtier.

L'embase 20 détermine un logement pour la partie arrière du module 10. Elle comporte un fond 21, des parois latérales sous forme de cloisons verticales 25,26, une paroi supérieure 27 et une paroi inférieure 28 horizontales. Le fond 21 est doté d'un dispositif de verrouillage élastique 30 sur le profilé R.

Le fond 21 présente des connexions frontales 23 aptes à coopérer avec les contacts 13 du module 10 lorsque l'embase est verrouillée sur le profilé R. L'embase a aussi des contacts latéraux 24 qui servent à transmettre les signaux de bus à destination ou en provenance des modules et les potentiels d'alimentation qui sont destinés aux modules ou aux organes d'automatisme. Les parois 25-28 comprennent des faces, glissières ou autres éléments de guidage facilitant l'introduction du module. Dans les cloisons 25,26 sont prévus des évidements 29 qui coopèrent avec des cliquets, parties élastiques ou autres formes de fixation 15 du module. Les formes 15 sont manoeuvrables par exemple par deux poussoirs supérieur et inférieur 16, afin de verrouiller le module 10 dans sa position enfoncée dans l'embase 20, position dans laquelle il est emboîté entre les parois 25-28.

Le dispositif de verrouillage 30 comporte deux crans opposés de fixation 30 (30-1,30-2) liés chacun à un coulisseau 31 (31-1,31-2) déplaçable selon une direction verticale Z, qui correspond à la longueur de l'embase 20 et qui est perpendiculaire à X. A son extrémité opposée au plan médian P de l'embase, chaque coulisseau se rattache à une partie rigide 32 du fond 21 de l'embase à la manière d'une liaison articulée, cette liaison autorisant néanmoins le glissement du coulisseau. Le coulisseau 31 est constitué par une partie même du fond 21, séparée de cloisons rigides 33 du fond par des fentes 34 dirigées selon Z.

Le dispositif de verrouillage 30 comporte un organe de déverrouillage constitué par un levier 40 pivotant autour d'un axe de tourillonnement X1 parallèle à la direction X. Le levier 40 présente à cet effet des tourillons latéraux 41 qui pivotent dans des orifices du fond 21. Le levier présente un bras de commande manuelle 42 et un corps de pivot muni de deux glissières de came 43 dans chacune desquelles peut se déplacer un axe 44 dirigé selon une direction X2,X3 parallèle à X et engagé d'une part dans un trou cylindrique 35 du coulisseau respectif 31 et d'autre part dans des fentes ou rainures oblongues 36, dirigées selon Z, et prévues dans des oreilles 37 du fond. Les oreilles 37 et le corps à glissières 43 sont disposés en saillie vers l'arrière dans un espace intermédiaire entre les zones de logement 38 des branches du profilé R1,R2, cette saillie se logeant dans le retrait central du profilé. Le levier occupe ainsi un espace très faible au fond de l'embase.

Un ressort de rappel en épingle 39 est associé à l'un des coulisseaux 31-2 pour s'arcbouter contre lui et le repousser vers le plan P.

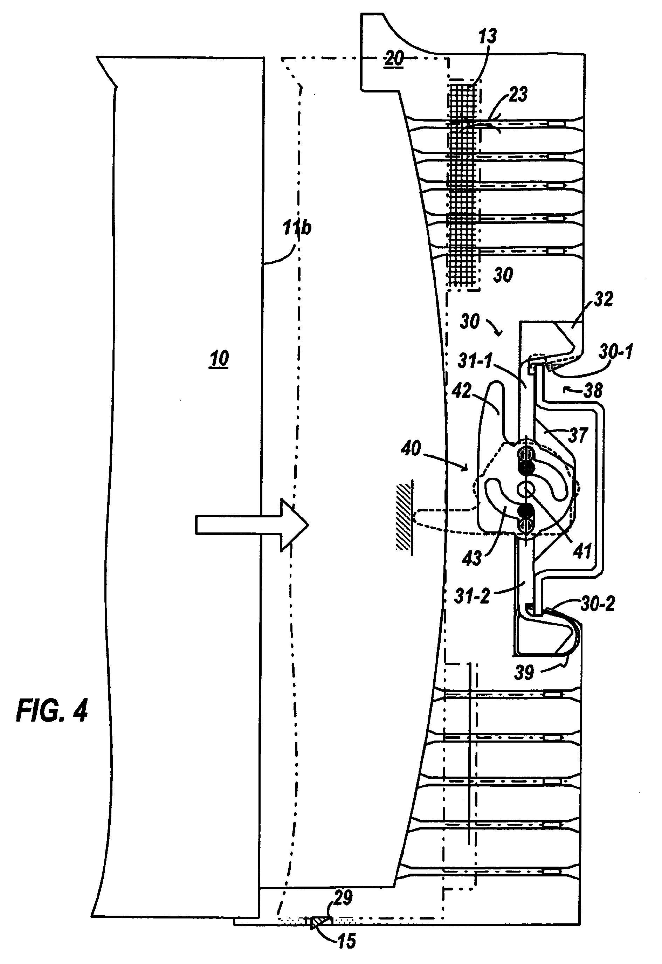

Comme on le voit figure 4, la paroi arrière 11b du module électronique bute contre le bras 42 de manoeuvre du levier 40 quand celui-ci occupe sa position sensiblement horizontale de déverrouillage (indiquée en tirets). Par contre, la paroi 11b autorise la fixation du module sur l'embase et la connexion des contacts 13 et 21 quand le bras 42 est amené dans sa position sensiblement verticale de verrouillage (en traits pleins). De même, quand le module est fixé et connecté, il interdit de déverrouiller l'embase 20 du profilé R.

Le fonctionnement du dispositif de verrouillage décrit va maintenant être explicité en regard des figures 4 à 7.

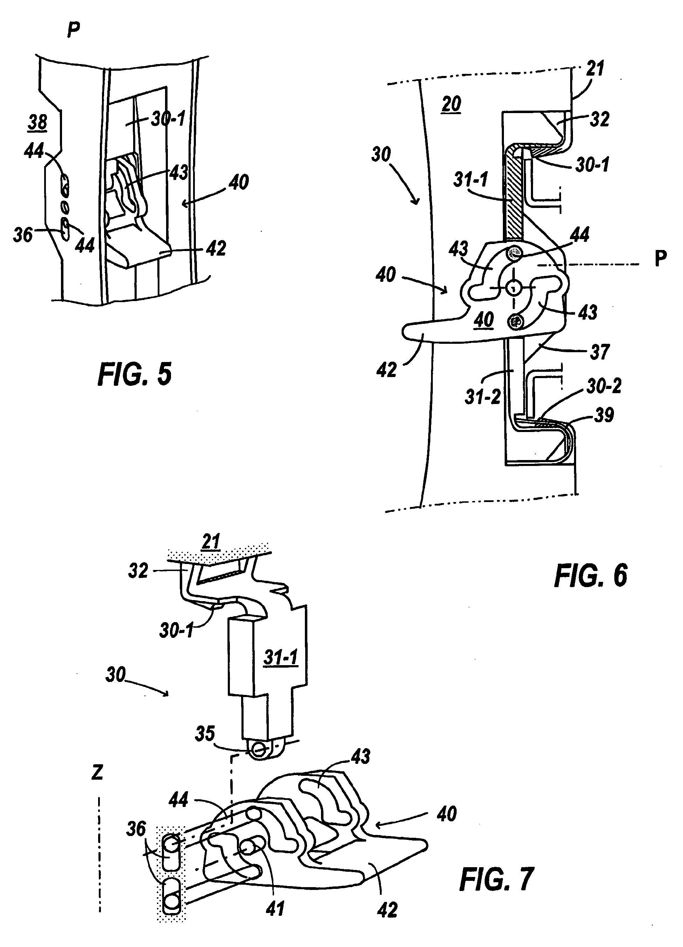

Le levier 40 étant dans sa position de déverrouillage (figures 5 et 6, ou en tirets figure 4) en étant maintenu dans cette position par des points durs ou d'encliquetage à seuil d'effort, les coulisseaux sont alors écartés (voir position en tirets figure 4) et l'embase peut ainsi être appliquée sur les branches du profilé R ; l'opérateur fait alors pivoter le levier vers sa position de verrouillage (voir position en traits pleins figure 4) et les coulisseaux viennent s'accrocher sur les bords des branches, le mouvement étant aidé par le ressort 38. Le levier reste maintenu dans cette position par un point dur ou d'encliquetage. Le module peut alors être engagé dans l'embase et lui être connecté et fixé. Tant que le levier 40 est dans la position déverrouillée, il n'est pas possible de glisser et connecter le module électronique 10 dans l'embase 20 (voir cette position illustrée en tirets sur la figure 4).

## Revendications

1. Appareil électrique comprenant une embase à fixer sur un profilé porteur, notamment un profilé chapeau, à branches coplanaires opposées, l'embase pouvant recevoir un organe constituant de l'appareil et étant dotée d'un dispositif de verrouillage à deux crans opposés de fixation (30) destinés à s'accrocher chacun sur une branche respective du profilé,
***caractérisé par le fait que***
- les deux crans de fixation (30-1, 30-2) sont déplaçables, en étant solidaire de coulisseaux (31-1, 31-2),
- les coulisseaux présentent chacun un axe parallèle à l'axe (X1) du tourillon,
- l'organe manuel de déverrouillage comprend un levier (40) monté pivotant autour d'au moins un tourillon (41) d'axe (X1) perpendiculaire à la direction (Z) de glissement des coulisseaux,
- le levier (40) coopère avec les deux coulisseaux par deux glissières de came (43) guidant chacune un axe (44) d'un coulisseau.

2. Appareil électrique selon la revendication 1, **caractérisé par le fait que** le tourillon (41) du levier pivotant (40) est situé près du fond (21) de l'embase.

3. Appareil électrique selon la revendication 1, **caractérisé par le fait que** les deux coulisseaux (31-1,31-2) sont symétriques par rapport à un plan médian (P) de l'embase et **par le fait que** les glissières de came (43) sont symétriques par rapport à l'axe (X1) du tourillon.

4. Appareil électrique selon la revendication 1, **caractérisé par le fait que** les glissières de came (43) sont intégrées au levier (40).

5. Appareil électrique selon la revendication 4, **caractérisé par le fait que** chaque axe (44) du coulisseau (31) est guidé dans une fente ou rainure (36) de l'embase (20), qui s'étend selon la direction (Z) de glissement du coulisseau.

6. Appareil électrique selon la revendication 1, **caractérisé par le fait que** l'embase (20) comporte une paroi de fond rigide et **par le fait que** chaque coulisseau vient de moulage avec le fond, en étant séparé de cloisons rigides (33) du fond par des fentes (34).

7. Appareil électrique selon la revendication 2, **caractérisé par le fait qu'**un ressort de rappel (39) en épingle est associé à l'un des coulisseaux (31-2).

8. Appareil électrique selon la revendication 2, **caractérisé par le fait que** le fond (21) présente deux logements (38) destinés à recevoir les branches du profilé chapeau et la partie du levier dotée des glissières de came (43) est disposée en saillie vers l'arrière entre ces logements.

9. Appareil électrique selon la revendication 1, **caractérisé par le fait que** le levier (40) est arrêté dans sa position de déverrouillage et dans sa position de verrouillage par des moyens de retenue à seuil d'effort.

10. Appareil électrique selon la revendication 1, **caractérisé par le fait que** l'appareil comprend un module électronique (10) fixé de manière amovible à l'embase (20), le levier pivotant (40) présentant un bras de manoeuvre effacé dans une position de verrouillage et en saillie vers l'avant dans une position de déverrouillage, afin de coopérer avec une face arrière du module pour interdire son montage sur l'embase dans la position de déverrouillage et le permettre dans la position de verrouillage.

## Claims

1. Electrical device comprising a base to be attached to a supporting rail, notably a top-hat rail, with opposite coplanar branches, the base being able to receive a constituent member of the device and being furnished with a locking device with two opposite attaching notches (30) designed to be coupled each to a respective branch of the rail,
**characterized in that**
- the two attaching notches (30-1, 30-2) can be moved, while being secured to slides (31-1, 31-2),
- the slides each have an axis parallel to the axis (X1) of the trunnion,
- the manual unlocking member comprises a lever (40) mounted so as to pivot around at least one trunnion (41) with an axis (X1) perpendicular to the direction (Z) of sliding of the slides,
- the lever (40) interacts with the two slides through two cam sliders (43) each guiding one axis (44) of a slide.

2. Electrical device according to Claim 1, **characterized in that** the trunnion (41) of the pivoting lever (40) is situated close to the bottom (21) of the base.

3. Electrical device according to Claim 1, **characterized in that** the two slides (31-1, 31-2) are symmetrical relative to a mid-plane (P) of the base and **in that** the cam sliders (43) are symmetrical relative to the axis (X1) of the trunnion.

4. Electrical device according to Claim 1, **characterized in that** the cam sliders (43) are incorporated into the lever (40).

5. Electrical device according to Claim 4, **characterized in that** each axis (44) of the slide (31) is guided in a slot or groove (36) of the base (20) which extends in the direction (Z) of sliding of the slide.

6. Electrical device according to Claim 1, **characterized in that** the base (20) comprises a rigid bottom wall and **in that** each slide is moulded in one piece with the bottom, while being separated from rigid partitions (33) of the bottom by slots (34).

7. Electrical device according to Claim 2, **characterized in that** a bow return spring (39) is associated with one of the slides (31-2).

8. Electrical device according to Claim 2, **characterized in that** the bottom (21) has two housings (38) designed to receive the branches of the top-hat rail and the portion of the lever furnished with cam sliders (43) is placed protruding rearwards between these housings.

9. Electrical device according to Claim 1, **characterized in that** the lever (40) is stopped in its unlocked position and in its locked position by force-limited retaining means.

10. Electrical device according to Claim 1, **characterized in that** the device comprises an electronic module (10) removably attached to the base (20), the pivoting lever (40) having an operating arm that is recessed in a locked position and protrudes forward in an unlocked position, in order to interact with a rear face of the module in order to prevent it being installed on the base in the unlocked position and to allow it in the locked position.

## Patentansprüche

1. Elektrisches Gerät, das einen auf einem Trägerprofil, insbesondere einem Hutprofil, mit gegenüberliegenden koplanaren Schenkeln zu befestigenden Sockel enthält, wobei der Sockel einen Bestandteil des Geräts aufnehmen kann und mit einer Verriegelungsvorrichtung mit zwei gegenüberliegenden Befestigungsrasten (30) versehen ist, die dazu bestimmt sind, je auf einem Schenkel des Profilteils einzurasten,
**dadurch gekennzeichnet, dass**
- die zwei Befestigungsrasten (30-1, 30-2) verschiebbar sind, indem sie mit Schiebern (31-1, 31-2) fest verbunden sind,
- die Schieber je eine Achse parallel zur Achse (X1) des Drehzapfens haben,
- das manuelle Entriegelungsorgan einen Hebel (40) enthält, der um mindestens einen Drehzapfen (41) einer Achse (X1) lotrecht zur Gleitrichtung (Z) der Schieber schwenkbar montiert ist,
- der Hebel (40) mit den zwei Schiebern über zwei Nockenschienen (43) zusammenwirkt, die je eine Achse (44) eines Schiebers lenken.

2. Elektrisches Gerät nach Anspruch 1, **dadurch gekennzeichnet, dass** der Drehzapfen (41) des Schwenkhebels (40) sich nahe dem Boden (21) des Sockels befindet.

3. Elektrisches Gerät nach Anspruch 1, **dadurch gekennzeichnet, dass** die zwei Schieber (31-1,31-2) bezüglich einer Mittelebene (P) des Sockels symmetrisch sind, und dass die Nockenschienen (43) bezüglich der Achse (X1) des Drehzapfens symmetrisch sind.

4. Elektrisches Gerät nach Anspruch 1, **dadurch gekennzeichnet, dass** die Nockenschienen (43) in den Hebel (40) integriert sind.

5. Elektrisches Gerät nach Anspruch 4, **dadurch gekennzeichnet, dass** jede Achse (44) des Schiebers (31) in einem Schlitz oder einer Nut (36) des Sockels (20) geführt wird, der/die sich entlang der Gleitrichtung (Z) des Schiebers erstreckt.

6. Elektrisches Gerät nach Anspruch 1, **dadurch gekennzeichnet, dass** der Sockel (20) eine steife Bodenwand aufweist, und dass jeder Schieber aus einem Stück mit dem Boden geformt wird, indem er von steifen Trennwänden (33) des Bodens durch Schlitze (34) getrennt ist.

7. Elektrisches Gerät nach Anspruch 2, **dadurch gekennzeichnet, dass** eine nadelförmige Rückstellfeder (39) einem der Schieber (31-2) zugeordnet ist.

8. Elektrisches Gerät nach Anspruch 2, **dadurch gekennzeichnet, dass** der Boden (21) zwei Aufnahmen (38) aufweist, die dazu bestimmt sind, die Schenkel des Hutprofils aufzunehmen, und der Teil des Hebels, der mit den Nockenschienen (43) versehen ist, nach hinten vorspringend zwischen diesen Aufnahmen angeordnet ist.

9. Elektrisches Gerät nach Anspruch 1, **dadurch gekennzeichnet, dass** der Hebel (40) in seiner Entriegelungsstellung und in seiner Verriegelungsstellung durch Halteeinrichtungen mit Kraftschwelle arretiert wird.

10. Elektrisches Gerät nach Anspruch 1, **dadurch gekennzeichnet, dass** das Gerät ein elektronisches Modul (10) enthält, das lösbar am Sockel (20) befestigt ist, wobei der Schwenkhebel (40) einen Betätigungsarm aufweist, der in einer Verriegelungsstellung eingezogen ist und in einer Entriegelungsstellung nach vorne vorsteht, um mit einer Rückseite des Moduls zusammenzuwirken, um seine Montage auf den Sockel in der Entriegelungsstellung zu verhindern und in der Verriegelungsstellung zu erlauben.
